(19) **Europäisches Patentamt**

**European Patent Office**

**Office européen des brevets**

(11) **EP 1 543 337 B1**

(12) **FASCICULE DE BREVET EUROPEEN**

(45) Date de publication et mention
de la délivrance du brevet:
**28.06.2006 Bulletin 2006/26**

(21) Numéro de dépôt: **03773783.0**

(22) Date de dépôt: **16.09.2003**

(51) Int Cl.:
***G01R 27/26*** (2006.01)

(86) Numéro de dépôt international:
**PCT/FR2003/002729**

(87) Numéro de publication internationale:
**WO 2004/029638 (08.04.2004 Gazette 2004/15)**

(54) **PROCEDE ET DISPOSITF POUR CARACTERISER DES MATERIAUX FERROELECTRIQUES**

VERFAHREN UND EINRICHTUNG ZUR CHARAKTERISIERUNG FERROELEKTRISCHER
MATERIALIEN

METHOD AND DEVICE FOR CHARACTERIZING FERROELECTRIC MATERIALS

(84) Etats contractants désignés:
**AT BE BG CH CY CZ DE DK EE ES FI FR GB GR
HU IE IT LI LU MC NL PT RO SE SI SK TR**

(30) Priorité: **27.09.2002 FR 0211990**

(43) Date de publication de la demande:
**22.06.2005 Bulletin 2005/25**

(73) Titulaires:
• **CENTRE NATIONAL DE
LA RECHERCHE SCIENTIFIQUE (CNRS)
75794 Paris Cedex 16 (FR)**
• **ECOLE NORMALE SUPERIEURE DE CACHAN
94235 Cachan (FR)**
Etats contractants désignés:
**FR**

(72) Inventeurs:
• **CIMA, Lionel
F-92330 Sceaux (FR)**
• **LABOURE, Eric
F-94230 Cachan (FR)**

(74) Mandataire: **Boire, Philippe Maxime Charles
Cabinet Plasseraud,
65/67, rue de la Victoire
F-75440 Paris Cedex 09 (FR)**

(56) Documents cités:
**US-A- 5 262 983**

**Description**

La présente invention concerne un procédé pour caractériser des matériaux ferroélectriques. Elle vise également un dispositif mettent en oeuvre ce procédé.

Les matériaux ferroélectriques sont caractérisés par les cycles d'hystérésis de la densité volumique de polarisation, $P$ (C/m$^2$), en fonction du champ électrique, $E$ (V/m). Les instruments de .caractérisation actuels permettent d'extraire des paramètres simples propres à ces cycles. Les cycles sont traditionnellement décrits par une polarisation rémanente (polarisation sous champ nul), une polarisation maximale, un champ coercitif et un champ de biais.

La forme des cycles d'hystérésis est pourtant très complexe et elle est étroitement liée à l'amplitude du champ électrique appliqué au sein du matériau, au processus d'élaboration du matériau, à la présence de défauts au sein du matériau, à la fréquence de mesure, etc. De nombreuses informations sont donc occultées si l'on se limite à la détermination de quelques paramètres seulement.

Un modèle théorique a été proposé par F. Preisach, dans l'article intitulé « Über die Magnetische Nachwirkung. » *Z. Phys.* 94, 277-302 (1935), pour représenter complètement la forme du cycle d'hystérésis, via une densité de basculements, dite densité de Preisach.

La détermination expérimentale précise de cette densité de Preisach repose sur un principe mathématique divulgué notamment dans l'article intitulé « Mathematical models of hysteresis », *IEEE Trans. Magn.* MAG-22, 603-608 (1986), par Mayergoyz, I. D.

Cette détermination nécessite un très grand nombre de mesures de cycles, puis un traitement de données. A l'heure actuelle les méthodes de mesure appliquées à la détermination de cette densité de Preisach n'utilisent que peu de mesures et reposent alors sur un a priori de la forme de cette densité. On parle de méthodes analytiques.

Le matériau ferroélectrique est généralement un bon diélectrique dont le comportement petits signaux est non linéaire. Ce comportement est décrit par l'effet "papillon" de la capacité petits signaux en fonction du champ électrique de repos. Ces effets ne peuvent pas être modélisés par une densité de Preisach et doivent donc être éliminés. La polarisation, $P(E)$, doit donc être décomposée en deux effets (Equation. 1), l'un localement réversible, $P_{rev}(E)$, et l'autre, localement irréversible, $P_{irr}(E)$. Les effets localement réversibles sont accessibles par une mesure de la capacité petits signaux. Seul les effets localement irréversibles peuvent être modélisés par une densité de Preisach. La parfaite séparation de ces deux effets n'est pas envisagée par les méthodes de caractérisation actuelles.

$$P(E) = P_{rev}(E) + P_{irr}(E) \qquad (1)$$

La polarisation localement irréversible représente l'état de basculements des domaines ferroélectriques, où dit autrement, la position des parois de domaines. Les déplacements de parois de domaines sont sujets à une certaine dynamique qui introduit des phénomènes transitoires complexes. Les phénomènes transitoires ne sont pas pris en compte par le modèle de Preisach et doivent donc être éliminés. L'élimination de ces phénomènes transitoires n'est pas envisagée dans les procédés de caractérisation actuels.

Le but de l'invention est de remédier à ces inconvénients en proposant un procédé de caractérisation permettant une élimination des phénomènes localement réversibles et des phénomènes transitoires dus aux déplacements de parois..

Cet objectif est atteint avec un procédé pour caractériser un matériau ferroélectrique, comprenant :

- une application d'une tension électrique sur un échantillon de ce matériau ferroélectrique,
- une mesure du courant électrique traversant cet échantillon,
- un traitement conjoint d'un signal de tension appliquée et d'un signal de courant mesuré, pour fournir des données représentatives de caractérisation de polarisation du matériau ferroélectrique.

Suivant l'invention, le procédé comprend en outre :

- un asservissement de la tension électrique appliquée, de façon à produire en superposition une première composante de courant à une première amplitude dite « grands signaux » à une première fréquence et une seconde composante de courant à une seconde amplitude dite « petits signaux » et à une seconde fréquence très supérieure à la première fréquence ; et
- une identification de caractéristiques du matériau ferroélectrique associées respectivement à des effets de polarisation localement réversibles et à des effets de polarisation localement irréversibles.

Avec la présente invention, on propose une instrumentation qui permet une parfaite extraction de la polarisation localement irréversible; ainsi qu'une élimination des phénomènes transitoires liés à la dynamique des déplacements de parois de domaines. Une détermination expérimentale de la densité de Preisach, ne nécessitant aucun a priori, est ensuite envisageable. Cette densité de Preisach expérimentale permet de caractériser le matériau ferroélectrique indépendamment de l'amplitude du champ électrique appliqué. Les influences de certains phénomènes liés à la présence de défauts peuvent être facilement observés, tels que la fatigue du matériau, ou le phénomène de biais local ("local imprint").

Suivant un autre aspect de l'invention, il est proposé un dispositif de caractérisation de matériaux ferroélectriques, mettant en oeuvre le procédé selon l'invention, comprenant :

-    des moyens pour appliquer une tension alternative sur un échantillon du matériau ferroélectrique,
-    des moyens pour mesurer le courant électrique traversant cet échantillon,
-    des moyens pour traiter conjointement un signal de tension appliquée et un signal de courant mesuré, pour fournir des données représentatives de caractérisation de polarisation du matériau ferroélectrique, caractérisé en ce qu'il comprend en outre :

-    des moyens pour asservir la tension électrique appliquée, de façon à produire en superposition une première composante dé courant à une première amplitude dite « grands signaux » à une première fréquence et une seconde composante de courant à une seconde amplitude dite « petits signaux » et à une seconde fréquence très supérieure à la première fréquence ; et
-    des moyens pour extraire à partie des données de traitement des caractéristiques du matériau ferroélectrique associés respectivement à des effets de polarisation localement réversibles et à des effets de polarisation localement irréversibles.

D'autres avantages et caractéristiques de l'invention apparaîtront à l'examen de la description détaillée d'un mode de mise en oeuvre nullement limitatif, et des dessins annexés sur lesquels :

-    la figure 1 illustre un montage à masse virtuelle mis en oeuvre, représentatif de l'art antérieur ;
-    la figure 2 illustre le principe de l'asservissement de la tension aux bornes de l'échantillon et de la mesure du courant absorbé par celui-ci, mis en oeuvre dans le procédé selon l'invention ;
-    la figure 3 représente une mesure simultanée de la capacité petits signaux, du courant absorbé par un échantillon de matériau ferroélectrique et de la tension imposée à ses bornes, obtenue avec un dispositif de caractérisation selon l'invention ;
-    la figure 4 représente une évolution temporelle du courant absorbé par l'échantillon et de la tension appliquée à ces bornes (présentant un palier aux extrémités);
-    la figure 5 illustre des densités effectives de basculements des domaines tracées dans le plan ($E_{max}$, E), obtenues avec un dispositif de caractérisation selon l'invention ; et
-    la figure 6 illustre une densité expérimentale de Preisach, en vue de dessus à gauche.

On va maintenant décrire le principe du procédé de caractérisation selon l'invention, en même temps que sa mise en oeuvre dans un appareil de caractérisation, en référence aux figures précitées.

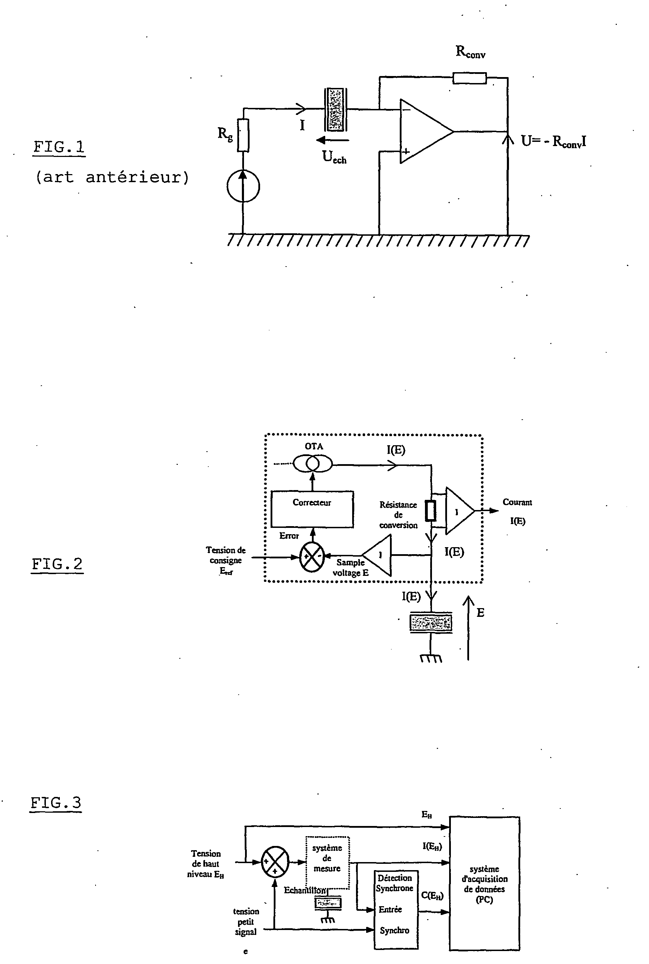

Pour réaliser une caractérisation d'un matériau ferroélectrique, il est nécessaire d'assurer une parfaite maîtrise de la tension imposée aux bornes de l'échantillon, ainsi qu'une mesure du courant absorbé par celui-ci. Lorsque la chute de tension dans l'impédance interne du générateur peut être négligée, un simple montage à masse virtuelle peut être utilisé, en référence à la figure 1.

Dans le procédé de caractérisation selon l'invention, un asservissement de la tension est prévu pour permettre des niveaux élevés d'absorption de courant. Un exemple d'asservissement basé sur l'utilisation d'un amplificateur opérationnel à transconductance est présenté sur la figure 2.

Le système de mesure permet donc d'imposer une certaine tension aux bornes de l'échantillon ferroélectrique, tout en mesurant le courant absorbé par celui-ci. Ce système de mesure est le coeur de l'instrumentation mise en oeuvre pour la détermination de la densité de Preisach.

Le courant mesuré au cours de cycles grands signaux et basse fréquence rend compte de tous les effets de polarisation incluant les effets réversibles et irréversibles.

Les effets localement réversibles peuvent être mesurés séparément par superposition à la tension grand signal, d'un signal sinusoïdal de très faible amplitude mais de haute fréquence. La capacité petits signaux est alors mesurée simultanément, par le biais d'une détection synchrone, en référence à la figure 3.

L'expression du courant absorbé par l'échantillon est rappelée par l'Equation. 2. Ce courant est décomposé en plusieurs effets décrits par l'Equation. 3. On reconnaît les effets de polarisation localement irréversibles, les effets localement réversibles ainsi que les effets dus à la capacité à vide (également réversibles).

$$I(E) = S \frac{d(\varepsilon_0 E + P(E))}{dt} \qquad (2)$$

$$I(E) = \left[ S\varepsilon_0 + S \frac{dP_{rev}(E)}{dE} + S \frac{dP_{irr}(E)}{dE} \right] \frac{dE}{dt} \qquad (3)$$

Le courant dépend du sens de variation du champ et, lorsque le champ est décroissant, de la dernière valeur maximale de champ atteinte, $E_{max}$. A partir de l'Equation 3, on déduit une expression du courant (Eq. 4) où apparaissent la capacité petits signaux, $C(E_{max}, E)$, l'épaisseur de l'échantillon, $h$, la surface de l'échantillon, S et la polarisation à saturation de l'échantillon, $P_{sat}$. La grandeur $H_{dec}(E_{max}, E)$ est appelée densité effective de basculements des domaines et représente les effets localement irréversibles.

$$I(E_{max}, E) = \left[ hC(E_{max}, E) + 2P_{sat}S H_{dec}(E_{max}, E) \right] \frac{dE}{dt} \qquad dE < 0 \qquad (4)$$

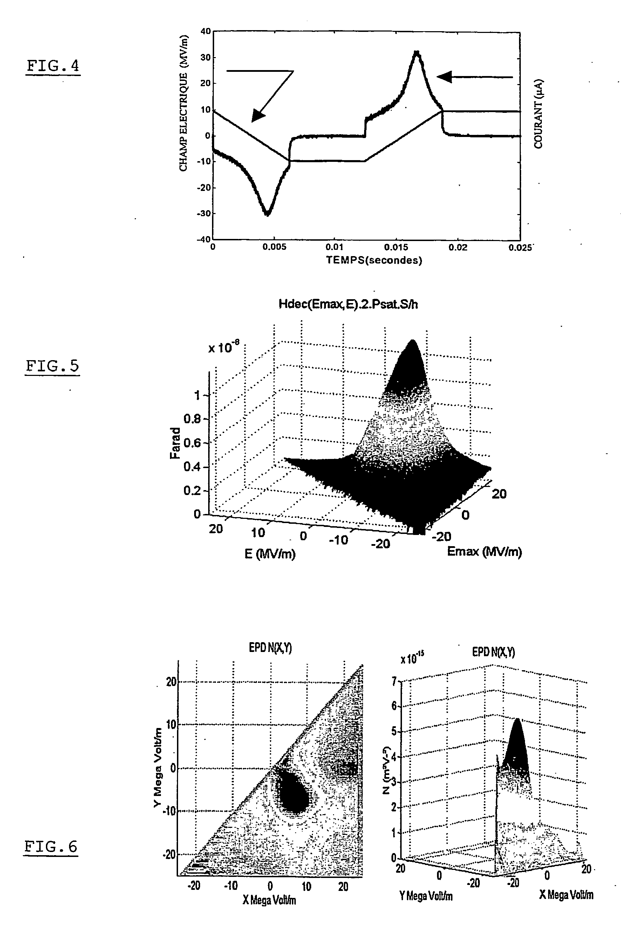

L'Equation 4 n'intègre pas la dynamique de déplacement des parois de domaines. Cette dynamique est à l'origine de phénomènes transitoires extrêmement gênants lors d'une rupture de pente du champ électrique. Le profil du champ électrique appliqué à l'échantillon est linéaire par morceau afin de faciliter le calcul de $dE/dt$. Les effets transitoires aux niveaux des extrémités (lorsque le champ change de sens) sont alors éliminés par des paliers de tension, en référence à la figure 4. Ces paliers permettent d'attendre que les phénomènes transitoires liés à la dynamique des parois de domaines soient terminés avant de lancer les acquisitions. Cette méthode permet quasiment d'éliminer l'influence de la fréquence de mesure sur la forme de la densité de Preisach.

La figure 5 montre les mesures collectées au cours d'une détermination de densités effectives de basculements des domaines suivant la méthode FORC décrite dans l'article « Mathematical models of hysteresis » précité. Ces données sont obtenues après élimination des effets transitoires et soustraction des effets localement réversibles.

La relation entre la densité de Preisach, N(X,Y) et ces densités effectives de basculement des domaines est donnée par Mayergoyz (Equation 5). En référence à la figure 6, la densité de Preisach peut donc être calculée à partir des données de la figure 5 collectées pour différentes valeurs de $E_{max}$.

$$N(E_{max}, E) = \frac{\partial H_{dec}(E_{max}, E)}{\partial E_{max}} \qquad dE < 0 \qquad (5)$$

Bien sûr, l'invention n'est pas limitée aux exemples qui viennent d'être décrits et de nombreux aménagements peuvent être apportés à ces exemples sans sortir du cadre de l'invention telle que définie par les revendications suivantes.

**Revendications**

1. Procédé pour caractériser un matériau ferroélectrique, comprenant :

- une application d'une tension électrique sur un échantillon de ce matériau ferroélectrique,
- une mesure du courant électrique traversant cet échantillon,
- une mesure simultanée de la capacité petits signaux de l'échantillon,
- un traitement conjoint d'un signal de tension appliquée, d'un signal de courant mesuré et d'un signal de capacité petits signaux, pour fournir des données représentatives de caractérisation de polarisation du matériau ferroélectrique,

**caractérisé en ce qu'**il comprend en outre :

- un asservissement de la tension électrique appliquée, de façon à produire en superposition une première composante de tension à une première amplitude dite « grands signaux » à une première fréquence et présentant des paliers aux extrémités, et une seconde composante de tension à une seconde amplitude dite « petits signaux » et à une seconde fréquence très supérieure à la première fréquence ; et
- une identification de caractéristiques du matériau ferroélectrique associés respectivement à des effets de polarisation localement réversibles et à des effets de polarisation localement irréversibles.

**2.** Dispositif de caractérisation de matériaux ferroélectriques, mettant en oeuvre le procédé selon la revendication 1, comprenant :

- des moyens pour appliquer une tension alternative sur un échantillon du matériau ferroélectrique,
- des moyens pour mesurer le courant électrique traversant cet échantillon,
- des moyens pour mesurer la capacité petits signaux de cet échantillon,
- des moyens pour traiter conjointement un signal de tension appliquée, un signal de courant mesuré et un signal de capacité petits signaux, des moyens pour fournir des données représentatives de caractérisation de polarisation du matériau ferroélectrique,

**caractérisé en ce qu'**il comprend en outre :

- des moyens pour asservir la tension électrique appliquée, de façon à produire en superposition une première composante de tension à une première amplitude dite « grands signaux » à une première fréquence et présentant des paliers aux extrémités, et une seconde composante de tension à une seconde amplitude dite « petits signaux » et à une seconde fréquence très supérieure à la première fréquence ; et
- des moyens (PC) pour extraire à partir des données de traitement des caractéristiques du matériau ferroélectrique associés respectivement à des effets de polarisation localement réversibles et à des effets de polarisation localement irréversibles.

**3.** Dispositif selon la revendication 2, dans lequel les moyens d'asservissement de tension comprennent un amplificateur opérationnel à transconductance.

**Claims**

**1.** A method for characterizing a ferroelectric material, comprising:

- applying an electrical voltage to a sample of this ferroelectric material;
- measuring the electrical current flowing through this sample;
- simultaneously measuring the small-signal capacitance of the sample ;
- jointly processing an applied voltage signal, a measured current signal and a small-signal capacitance signal, so as to provide representative data characterizing the polarization of the ferroelectric material,

**characterized in that** it furthermore includes:

- feedback controlling the applied electrical voltage so as to superpose a first voltage component with a first amplitude called "large-signal" at a first frequency, and having plateaus at the ends, on a second voltage component with a second amplitude called "small-signal" at a second frequency very much higher than the first frequency; and
- identifying characteristics of the ferroelectric material that are associated with locally reversible polarization effects and with locally irreversible polarization effects, respectively.

**2.** A device for characterizing ferroelectric materials, implementing the method according to Claim 1, comprising:

- means for applying an AC voltage to a sample of the ferroelectric material;
- means for measuring the electrical current flowing through this sample;
- means for measuring the small-signal capacitance of this sample ;
- means for jointly processing an applied voltage signal, a measured current signal and a small-signal capacitance signal, means for providing representative data for characterizing the polarization of the ferroelectric material,

**characterized in that** it furthermore includes:

- means for feedback controlling the applied electrical voltage so as to superpose a first voltage component with a first amplitude called "large-signal" at a first frequency, and having plateaus at the ends, on a second voltage component with a second amplitude called "small-signal" at a second frequency very much higher than the first frequency; and
- means (PC) for extracting characteristics of the ferroelectric material that are associated with locally reversible polarization effects and with locally irreversible polarization effects, respectively, from the processing data.

3. The device according to Claim 2, wherein the voltage feedback control means comprise a transconductance operational amplifier.

## Patentansprüche

1. Verfahren zur Bestimmung eines ferroelektrischen Werkstoffs, welches umfasst:

- das Anlegen einer elektrischen Spannung an eine Probe dieses ferroelektrischen Werkstoffs,
- das Messen des elektrischen Stroms, der durch diese Probe fließt,
- gleichzeitiges Messen der Kapazität niedriger Signale der Probe,
- in Verbindung miteinander erfolgendes Verarbeiten eines Signals der angelegten Spannung, eines Signals für den gemessenen Strom und eines Signals der Kapazität niedriger Signale, um repräsentative Kenndaten der Polarisation der ferroelektrischen Probe zur Verfügung zu stellen,

**dadurch gekennzeichnet,**
**dass** es des weiteren umfasst:

- eine Steuerung der angelegten elektrischen Spannung dergestalt, dass in Überlagerung eine erste Spannungskomponente mit einer ersten Amplitude, sogenannten "hohen Signalen", mit einer ersten Frequenz, die Stufen an den Enden aufweist, sowie eine zweite Spannungskomponente mit einer zweiten Amplitude, sogenannten "niedrigen Signalen", und mit einer zweiten Frequenz, die sehr viel höher als die erste Frequenz ist, erzeugt wird, und
- eine Identifizierung von Merkmalen des ferroelektrischen Werkstoffs in Verbindung mit lokal reversiblen Polarisationseffekten bzw. mit lokal irreversiblen Polarisationseffekten.

2. Vorrichtung zur Bestimmung ferroelektrischer Werkstoffe, bei der das Verfahren nach Anspruch 1 angewendet wird, bestehend aus:

- Mitteln zum Anlegen einer Wechselspannung an eine Probe dieses ferroelektrischen Werkstoffs,
- Mitteln zum Messen des durch diese Probe fließenden elektrischen Stroms,
- Mitteln zum Messen der Kapazität niedriger Signale dieser Probe,
- Mitteln, um in Verbindung miteinander ein Signal der angelegten Spannung, ein Signal für den gemessenen Strom und ein Signal der Kapazität niedriger Signale zu verarbeiten, Mitteln, um repräsentative Kenndaten der Polarisation des ferroelelctrischen Werkstoffs zur Verfügung zu stellen,

**dadurch gekennzeichnet,**
**dass** sie des weiteren umfasst:

- Mittel zur Steuerung der angelegten elektrischen Spannung, so dass in Überlagerung eine erste Spannungskomponente mit einer ersten Amplitude, sogenannten "hohen Signalen", mit einer ersten Frequenz, die Stufen an den Enden aufweist, sowie eine zweite Spannungskomponente mit einer zweiten Amplitude, sogenannten "niedrigen Signalen", und mit einer zweiten Frequenz, die sehr viel höher als die erste Frequenz ist, erzeugt wird, und
- Mittel (PC), um aus den Verarbeitungsdaten Merkmale des ferroelektrischen Werkstoffs in Verbindung mit lokal reversiblen Polarisationseffekten bzw. mit lokal irreversiblen Polarisationseffekten zu gewinnen.

**3.** Vorrichtung nach Anspruch 2, bei der die Mittel zur Steuerung der Spannung einen Transkonduktanz-Operationsverstärker umfassen.

FIG.1
(art antérieur)

$R_{conv}$

$R_g$

I

$U_{ech}$

$U = -R_{conv}I$

FIG.2

OTA

I(E)

Correcteur

Résistance
de
conversion

Courant
I(E)

Error

I(E)

Tension de
consigne
$E_{ref}$

Sample
voltage E

I(E)

I(E)

E

FIG.3

$E_H$

système
de
mesure

$I(E_H)$

Tension
de haut
niveau $E_H$

Echantillon

Détection
Synchrone

Entrée

$C(E_H)$

système
d'acquisition
de données
(PC)

tension
petit
signal

Synchro

e

FIG.4

FIG.5

Hdec(Emax,E).2.Psat.S/h

FIG.6